**Europäisches Patentamt**

**European Patent Office**

**Office européen des brevets**

(19)

(11) Veröffentlichungsnummer: **0 013 945**
A1

## (12) EUROPÄISCHE PATENTANMELDUNG

(21) Anmeldenummer: **80100227.0**

(22) Anmeldetag: **17.01.80**

(51) Int. Cl.³: **G 01 R 13/00**, G 01 R 17/04, G 01 R 13/40

(30) Priorität: **23.01.79 DE 2902475**

(43) Veröffentlichungstag der Anmeldung: **06.08.80**
**Patentblatt 80/16**

(84) Benannte Vertragsstaaten: **CH FR GB NL**

(71) Anmelder: **SIEMENS AKTIENGESELLSCHAFT,**
**Postfach 22 02 61, D-8000 München 22 (DE)**

(72) Erfinder: **Lugos, Attila, Dipl.-Ing., Rue Thomas**
**Becquet 4, F-67500 Haguenau (FR)**

(54) **Aufzeichnungsgerät für elektrische Signale.**

(57)    Die Erfindung bezieht sich auf ein Aufzeichnungsgerät, das Meßwertkurven auf einen Registrierstreifen schreibt, indem Zeile für Zeile die Kurvenwerte mit zeitlinear ansteigenden Referenzwerten verglichen werden und bei Gleichheit ein Steuerimpuls zum Schreiben eines Kurvenpunktes abgegeben wird, dessen Abstand von einer Nullinie der Größe des Kurvenwertes entspricht.

Bei raschen Änderungen der Kurvenwerte können die Kurvenpunkte weit auseinanderliegen, so daß der Kurvenverlauf nicht leicht zu erkennen ist. Die vorliegende Erfindung hat zum Ziel, auch bei raschen Änderungen der Kurvenwerte geschlossene Kurven zu schreiben.

Dieses Ziel wird dadurch erreicht, daß zwei Vergleicher (VGL1, VGL2) vorgesehen sind, deren einen das in der einen Schreibzeile aufgezeichnete Signal und deren anderen das in der folgenden Schreibzeile aufzuzeichnende Signal und denen beiden die Referenzwerte zugeführt sind, und daß an die Vergleicher (VGL1, VGL2) eine Verknüpfungsschaltung (EXO) angeschlossen ist, die ein Steuersignal an das Aufzeichnungselement (AFE1; AFE2) abgibt, solange der Referenzwert kleiner als der in der einen Schreibzeile aufgezeichnete Signalwert und größer als der in der folgenden Zeile aufzuzeichnende Signalwert ist oder solange der Referenzwert größer als der in der einen Schreibzeile aufgezeichnete Signalwert und kleiner als der in der folgenden Zeile aufzuzeichnende Signalwert ist.

– 1 –

SIEMENS AKTIENGESELLSCHAFT          Unser Zeichen
Berlin und München                 VPA 79 P 3502

Aufzeichnungsgerät für elektrische Signale

Die Erfindung betrifft ein Aufzeichnungsgerät mit einem Aufzeichnungselement, das auf einen Aufzeichnungsstreifen in senkrecht zu dessen Vorschubrichtung verlaufenden Schreibzeilen Punkte darstellt, und mit einem Vergleicher, dem das aufzuzeichnende Signal und ein Vergleichssignal zugeführt sind und der bei Gleichheit der beiden zugeführten Signale an das Aufzeichnungselement ein Steuersignal zum Aufzeichnen eines Punktes gibt, dessen Abstand von einer Bezugslinie der Größe des aufzuzeichnenden Signals entspricht.

Derartige Aufzeichnungsgeräte sind in verschiedenen Ausführungsformen bekannt. In der DE-OS 24 04 550 ist z. B. ein Aufzeichnungsgerät beschrieben, bei dem quer zur Vorschubrichtung eines lichtempfindlichen Aufzeichnungsstreifens eine Reihe Leuchtdioden angeordnet ist. Der aufzuzeichnende Meßwert wird mit der zeitlinear ansteigenden Vergleichsspannung verglichen. Synchron mit der Vergleichsspannung werden die Leuchtdioden abgetastet.

Zin 4 Bz / 29.12.1978

Tritt eine Koinzidenz des aufzuzeichnenden Meßwertes mit dem Augenblickswert der Vergleichsspannung auf, so leuchtet die Leuchtdiode auf, die gerade abgetastet wird.

Zeilenweises Beschreiben eines Aufzeichnungsstreifens mit Punkten ist auch mit Geräten möglich, die feststehende, quer zur Vorschubrichtung des Aufzeichnungsstreifens kammartig angeordnete Schreibstifte oder Elektroden aufweisen. Solche Geräte sind z. B. die sogenannten Thermokammschreiber, bei denen Thermowiderstände als Schreibelement vor einem wärmeempfindlichen Aufzeichnungsstreifen angeordnet sind. Im Falle der Gleichheit von Vergleichs- und Meßsignal wird der dem jeweiligen Meßwert entsprechende Thermowiderstand erhitzt und damit ein dem Meßwert entsprechender Kurvenpunkt auf den Registrierstreifen gezeichnet.

Ferner sind Aufzeichnungsgeräte vorgeschlagen worden, bei denen ein Schreibkopf vor dem Aufzeichnungsstreifen senkrecht zu dessen Vorschubrichtung hin- und hergefahren wird und dadurch den Aufzeichnungsstreifen zeilenweise beschreibt. Das Vergleichssignal hat stets eine Größe, die dem Abstand des Schreibkopfes, z. B. eines Tintenstrahlschreibers, von einer in Vorschubrichtung verlaufenden Bezugslinie entspricht. Stellt der Vergleicher Gleichheit zwischen dem aufzuzeichnenden Signal und dem Vergleichssignal fest, gibt er einen Steuerimpuls ab, der das Aufzeichnen eines dem jeweiligen Meßwert entsprechenden Bildpunktes, z. B. die Abgabe eines Tintentröpfchens, auslöst.

Die Vergleichsspannung hat im allgemeinen einen zeitlinearen Verlauf. In dem erstgenannten Beispiel, bei dem kein Schreibkopf vor dem Aufzeichnungsstreifen bewegt wird, kann die Vergleichsspannung sägezahnförmig verlaufen. Aufzeichnungsgeräte mit einem hin- und herbewegten Schreibkopf wird man so betreiben, daß auf dem
Hin- und Rückweg des Schreibkopfes Bildpunkte dargestellt werden, so daß keine Zeit für den Rücklauf des
Schreibkopfes verlorengeht. Bei zeitlinearem Verfahren
des Schreibkopfs ist daher das Vergleichssignal dreiecksförmig. Die erheblichen Abbrems- und Beschleunigungskräfte an den Umkehrpunkten des Schreibkopfes können dadurch herabgesetzt werden, daß dessen Bewegung
sowie das Vergleichssignal etwa sinusförmig verlaufen
oder daß während der Abbrems- und Beschleunigungsphase
kein Vergleich stattfindet, die Bewegungsumkehr also
außerhalb des Aufzeichnungsstreifens liegt.

Bei derartigen Aufzeichnungsgeräten tritt das Problem
auf, daß bei schnellen Änderungen des aufzuzeichnenden
Eingangssignals die aufgezeichneten Punkte weit auseinanderliegen, so daß keine zusammenhängende Kurve erhalten wird und der Verlauf des Signals nur schwierig erkannt werden kann. Dieses Problem wurde bei einem Aufzeichnungsgerät, das in der Zeitschrift "Instruments
and Control Systems" Band 41, Juli 1968, Seiten 80 bis
82 beschrieben ist, dadurch zu lösen versucht, daß das
analoge Eingangssignal einem Analog-Digital-Umsetzer
zugeführt ist, dessen Ausgangswert sich nur jeweils um
Eins ändert. Dieses bekannte Gerät weist als Schreibelemente ein System von kammartig über die Schreibbreite angeordneten Elektroden auf, die ein elektrographisch zu entwickelndes Ladungsbild auf dem Registrierstreifen erzeugen. Jedem Meßwert ist eine Elektrode zugeordnet. Nach jeder Analog-Digital-Umsetzung
wird die dem Digitalwert zugeordnete Elektrode angesteuert, so daß sich, da sich die Digitalwerte nur um
Eins ändern, ein geschlossener Kurvenzug ergibt. Dieses bekannte Gerät gehört somit zu einer anderen Gattung als die vorliegende Erfindung. Gleiches gilt für ein aus der DE-OS 25 55 292 bekanntes Verfahren. Dort geht es darum, Punkte von Kurven, die auf dem Bildschirm eines Fernsehsichtgerätes dargestellt werden, miteinander zu verbinden.

Der vorliegenden Erfindung liegt demgegenüber die Aufgabe zugrunde, zusammenhängende Kurven mit einem Aufzeichnungsgerät der eingangs beschriebenen Art zu schreiben.

Erfindungsgemäß wird diese Aufgabe mit den im kennzeichnenden Teil des Anspruchs 1 angegebenen Schaltungsmaßnahmen gelöst.

Das erfindungsgemäße Aufzeichnungsgerät kann analog oder digital arbeiten, d. h. die den Vergleichern zugeführten Signale können digital oder analog dargestellt sein. Während Vergleicher für Analogsignale im allgemeinen nur einen Ausgang haben, an dem als Vergleichsergebnis entweder das Signal log. "1" oder "0" auftritt, haben Vergleicher für Digitalsignale in der Regel drei Ausgänge. An jeweils einem von ihnen tritt "1"- oder "0"-Signal auf, je nachdem, ob das Vergleichssignal größer, kleiner oder gleich dem aufzuzeichnenden Signal ist. Welchen Aufbau die an die Vergleicher angeschlossene Verknüpfungsschaltung hat, hängt davon ab, welche Vergleicherausgänge benutzt werden. Zweckmäßig wird ein einfaches, handelsübliches Exklusiv-ODER-Glied eingesetzt, dessen beide Eingänge an einander entsprechende Vergleicherausgänge angeschlossen sind, d. h. an die Ausgänge, die übereinstimmende Signale abgeben, wenn das Eingangssignal größer als das Vergleichssignal oder wenn das Eingangssignal kleiner als das Vergleichssignal ist. Da zwei in verschiedenen, aber aufeinanderfolgenden Abtastzeilen aufgezeichnete Signale miteinander verglichen werden, wird man zumindest ein Register als Zwischenspeicher für ein Signal vorsehen.

Anhand der Zeichnung werden im folgenden weitere Ausgestaltungen der Erfindung näher beschrieben und erläutert.

Figur 1 zeigt ein Prinzipschaltbild eines Ausführungsbeispieles mit einem einzigen Register und
Figur 2 ein Ausführungsbeispiel mit zwei Registern.
Figur 3 veranschaulicht die Aufzeichnung von Kurven mit den Ausführungsbeispielen nach Figur 1 und 2.

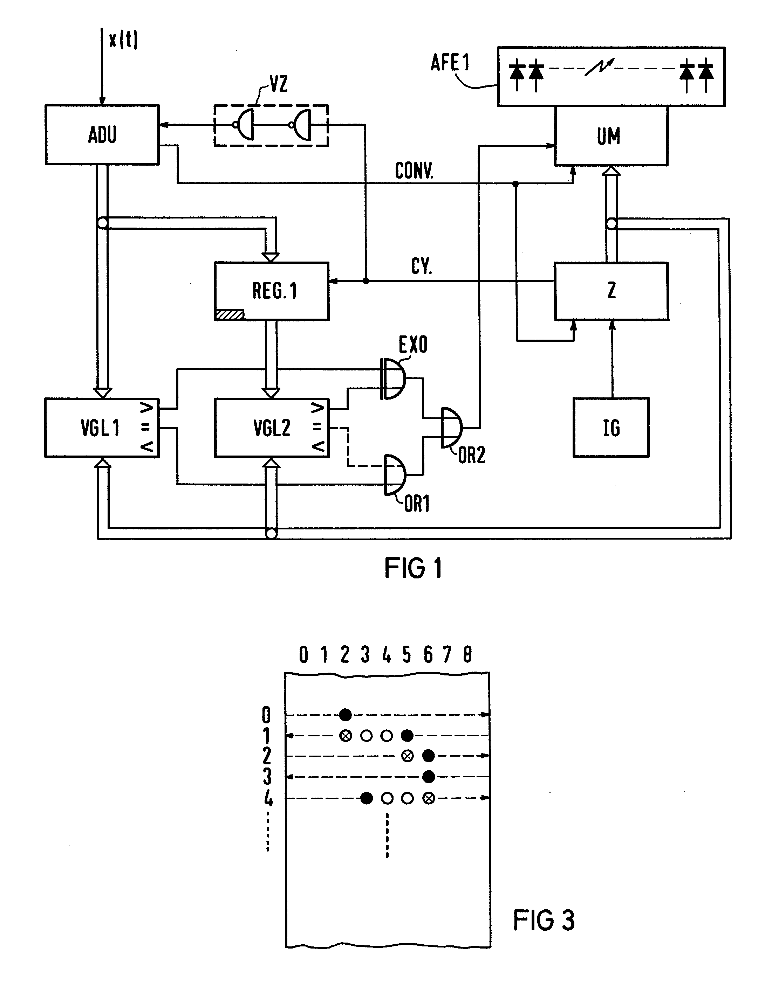

In Figur 1 ist mit AFE1 ein Aufzeichnungselement bezeichnet, das eine Reihe von Leuchtdioden enthält, die senkrecht zur Vorschubrichtung eines nicht dargestellten, lichtempfindlichen Aufzeichnungsstreifens angeordnet sind. Die Anzahl der Leuchtdioden entspricht der gewünschten Auflösung der Aufzeichnung. Die Leuchtdioden werden der Reihe nach von einem Umsetzer UM vorbereitet, der an einen zyklisch Impulse eines Impulsgebers IG aufsummierenden Zähler Z angeschlossen ist. Jedem Zählerstand ist eine Leuchtdiode zugeordnet. Jeweils die Diode ist zum Aufleuchten vorbereitet, deren zugehöriger Zählerstand dem Aufzeichnungselement AFE1 zugeführt ist. Diese Diode leuchtet nur dann auf, wenn von einem ODER-Glied OR2 ein zusätzliches Freigabesignal zugeführt ist.

Der Stand des Zählers Z gelangt ferner auf den einen Eingang eines Vergleichers VGL1, dessen anderer Eingang an einen Analog-Digital-Umsetzer ADU angeschlossen ist, dem das aufzuzeichnende Eingangssignal zugeführt ist. Mit den auf eine Leitung CY gegebenen Übertragimpulsen des Zählers Z, d. h., wenn die letzte Diode, die dem höchsten Zählerstand zugeordnet ist, zur Ansteuerung vorbereitet ist, setzt der Analog-Digital-Umsetzer ADU das Eingangssignal in einen Digitalwert um bzw. schaltet ein bereits verschlüsseltes Signal auf den Ausgang. Damit sichergestellt ist, daß der Analog-Digital-Umsetzer nicht während des Hochzählens des Zählers Z einen neuen Wert ausgibt, wird dem Zähler Z während der Umsetzzeit ein Sperrsignal CONV zugeführt. Mit diesem Signal kann ferner der Umsetzer UM gesperrt werden. Das verschlüsselte Signal gelangt nicht nur auf den Vergleicher VGL1, sondern auch auf den Eingang eines Registers REG1, in das es aber erst mit dem nächsten Übertragimpuls des Zählers Z übernommen wird. Kurz darauf erscheint ein neuer Digitalwert am Ausgang des Analog-Digital-Umsetzers ADU. Damit sicher erst der alte Wert in das Register REG1 eingetragen wird, bevor der neue Wert am Ausgang des Analog-Digital-Umsetzers ADU erscheint, ist dessen Steuereingang ein Verzögerungsglied VZ vorgeschaltet. Im Register REG1 ist daher während eines Vorbereitungszyklus der Leuchtdioden immer der Digitalwert gespeichert, der während des vorangegangenen Vorbereitungszyklus dem Vergleicher VGL1 zugeführt wurde. Der gespeicherte Wert wird einem Vergleicher VGL2 zugeführt, der ebenso wie der Vergleicher VGL1 als Vergleichssignal den Stand des Zählers Z erhält. An die beiden ">"-Eingänge der beiden Vergleicher VGL1, VGL2 ist ein Exklusiv-ODER-Glied EXO angeschlossen, dessen Ausgang auf das ODER-Glied OR2 geführt ist, die beiden "="-Ausgänge sind über ein ODER-Glied OR1 verknüpft, an das der zweite Eingang des ODER-Gliedes OR2 angeschlossen ist. Das ODER-Glied OR1 und dessen Verbindung zum "="-Ausgang des Vergleichers VGL2 kann ohne wesentliche Beeinträchtigung der Darstellung entfallen.

Anhand der Figur 3 wird die Funktion der Anordnung nach Figur 1 näher erläutert. Der Einfachheit halber ist angenommen, daß das Eingangssignal mit nur neun Amplitudenstufen aufgezeichnet werden soll. In der Zeile 0 sei der Wert 2 aufgezeichnet worden. Dann steht bei Beginn des Schreibens der Zeile 1 der Wert 2 im Register REG1, und am Eingang des Vergleichers VGL1 liegt der Wert 5. Erreicht der Zähler Z den Stand 2, gibt der Vergleicher VGL2 an seinem "="-Ausgang "1"-Signal ab, das, falls die gestrichelt gezeichnete Leitung und das ODER-Glied OR1 vorhanden sind, auf den Steuereingang des Aufzeichnungselementes AFE1 gelangt und das Aufleuchten der dem Zählerstand 2 zugeordneten Diode bewirkt. In der Zeile 1 wird daher die Amplitudenstufe 2 markiert. Beim Stand 3 des Zählers Z gibt der Vergleicher VGL2 an seinem ">"-Ausgang ein Signal ab, da er vom Register REG1 nur den Wert 2 erhält. Der Vergleicher VGL1 liefert dagegen an seinen ">"-Ausgang "0"-Signal, so daß das Exklusiv-ODER-Glied EXO ein Signal abgibt und die dem Stand 3 des Zählers Z zugeordnete Diode aufleuchtet. Entsprechend leuchtet beim Zählerstand 4 die nächste Diode auf. Beim Zählerstand 5 führt sowohl das Exklusiv-ODER-Glied EXO als auch der "="-Ausgang des Vergleichers VGL1 und damit das ODER-Glied OR1 "1"-Signal. Am Ende des Schreibens der Zeile 1 gibt der Zähler Z einen Übernahmeimpuls auf das Register REG1, so daß in dieses der Wert 5 übernommen wird, und über ein Verzögerungsglied VZ einen Steuerimpuls auf den Analog-Digital-Umsetzer ADU, so daß an dessen Ausgang der nächste Wert erscheint, der im Beispiel 6 sein soll. Beim Schreiben der Zeile 2 werden dann entsprechend der beschriebenen Abtastung der Zeile 1 die Amplitudenstufen 5 und 6 markiert. Gleiches gilt für die Zeile 3, nur mit dem Unterschied, daß das Exklusiv-ODER-Glied EXO kein "1"-Signal abgibt, da die Signale an den ">"-Ausgängen der Vergleicher VGL1, VGL2 stets gleich sind.

Beim Schreiben der Zeile 4 wird dem Vergleicher VGL1 vom Analog-Digital-Umsetzer ADU der Wert 3 und dem Vergleicher VGL2 vom Register REG1 der Wert 6 zugeführt. Beim Zählerstand 3 wird vom Signal am "="-Ausgang des Vergleichers VGL1 ein Steuersignal für das Aufzeichnungselement AFE1 abgeleitet, bei den Zählerständen 4 und 5 vom Ausgangssignal des Exklusiv-ODER-Gliedes EXO und beim Zählerstand 6 vom Signal am "="-Ausgang des Vergleichers VGL2.

Die in Figur 3 als Kreisflächen dargestellten Punkte entsprechen den Signalwerten. Mit Kreisringen sind Punkte dargestellt, die gemäß der vorliegenden Erfindung die den Signalwerten entsprechenden Punkte zu einer geschlossenen Kurve ergänzen. Von diesen Punkten können die mit einem Kreuz gekennzeichneten weggelassen werden, indem in der Anordnung nach Figur 1 die gestrichelt gezeichnete Leitung am "="-Ausgang des Vergleichers VGL2 sowie das ODER-Glied OR1 weggelassen wird.

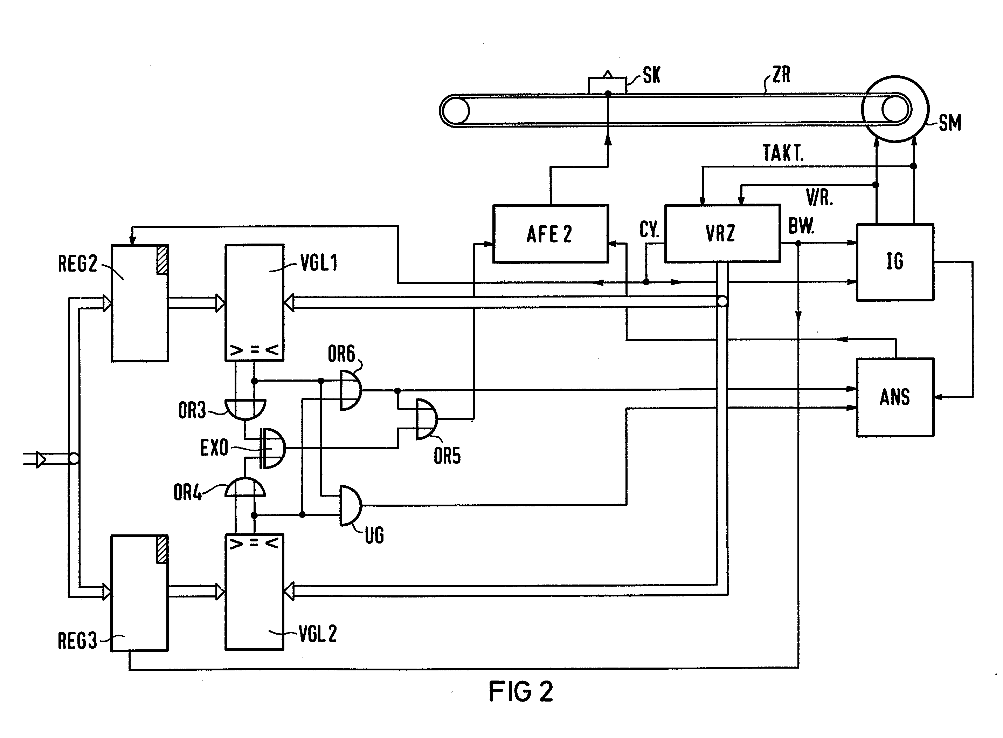

Das Aufzeichnungsgerät nach Figur 2 weist einen Schreibkopf SK auf, der an einem Zahnriemen ZR befestigt ist und mittels eines Schrittmotors SM hin- und herbewegt wird. Die Impulse für den Schrittmotor SM liefert ein Impulsgeber IG, an den ferner ein Zweirichtungszähler VRZ angeschlossen ist. Der Impulsgeber IG bestimmt die Drehrichtung des Schrittmotors SM und die Zählrichtung des Zählers VRZ. Stellung des Schreibkopfes SK auf dem Zahnriemen ZR, Drehzahl des Schrittmotors SM und Zählerstand sowie Zählkapazität des Zählers VRZ sind so aufeinander abgestimmt, daß beim einen Endzählerstand der Schreibkopf SK in der einen Endstellung ist und beim anderen Endzählerstand in der anderen Endstellung. Der jeweilige Zählerstand gibt daher an, in welcher Position sich der Schreibkopf SK befindet. Bei Erreichen der beiden Endzählerstände gibt der Zähler VRZ Steuerimpulse auf den Impulsgeber IG, welcher daraufhin die Drehrichtung des Schrittmotors SM und die Zählrichtung des Zählers VRZ umkehrt.

Der Stand des Zählers VRZ wird wieder den einen Eingängen der beiden Vergleicher VGL1, VGL2 zugeführt, deren zweite Eingänge an je ein Register REG2, REG3 angeschlossen sind. Den Eingängen dieser Register ist das im Ausführungsbeispiel digitale Eingangssignal parallel zugeführt. Die Übernahmeimpulse werden von den Endwerten des Zählers VRZ abgeleitet.

Die Ausgangssignale der Vergleicher VGL1 und VGL2 können in gleicher Weise wie in der Anordnung nach Figur 1 verknüpft werden. Es sind jedoch auch andere Schaltungen möglich. Die ">"- und "="-Ausgänge der Vergleicher sind über ODER-Glieder OR3, OR4 verknüpft dem Exklusiv-ODER-Glied EXO zugeführt. Ein ODER-Glied OR6, dessen Eingänge an die "="-Ausgänge der Vergleicher VGL1, VGL2 angeschlossen sind, steuert ein ODER-Glied OR5 an, das ferner mit dem Exklusiv-ODER-Glied EXO verbunden ist. Die Ausgangssignale dieses ODER-Gliedes OR5 werden als Steuersignale einem Aufzeichnungselement AFE2 zugeführt. Auf jeden dieser Steuerimpulse schreibt das Element AFE2 mit dem Schreibkopf SK einen Kurvenpunkt. Die Anordnung nach Figur 2 arbeitet in der Weise, daß die aufzuzeichnenden Signale abwechselnd in eines der beiden Register REG3, REG4 übernommen werden, so daß beim Schreiben einer Zeile der neueste Wert z. B. im Register REG2 und der ältere Wert im Register REG3 steht und beim Schreiben der folgenden Zeile der neueste Wert im Register REG3 und der ältere im Register REG2 enthalten ist. Selbstverständlich kann die Schaltungsanordnung nach Figur 2 auch zur Steuerung von anderen zeilenweise schreibenden Aufzeichnungsgeräten verwendet werden, z. B. in Verbindung mit dem eine Reihe von Lumineszenzdioden aufweisenden Gerät nach Figur 1 oder mit eine Reihe von Thermowiderständen enthaltenden Geräten. Die an die Vergleicher VGL1, VGL2 angeschlossene Verknüpfungsschaltung mit den ODER-Gliedern OR3, OR4, OR5 und OR6 sowie dem Exklusiv-ODER-Glied EXO ist nach der Erläuterung der Verknüpfungsschaltung nach Figur 1 aus sich heraus verständlich und bedarf keiner Erläuterung.

Sollen mit den Kurven alphanumerische Texte auf den Registrierstreifen geschrieben werden, so kann verhindert werden, daß Kurven und alphanumerische Texte sich überlagern, indem aus den Ausgangssignalen der Vergleicher VGL1, VGL2 Freigabe- bzw. Sperrsignale für eine alphanumerische Schreibeinrichtung ANS abgeleitet werden. Diese Signale können beispielsweise vom ODER-Glied OR6, dessen Impulse Anfang und Ende der Verbindungslinien zwischen den Kurvenpunkten angeben, oder einem UND-Glied UG, das dann ein Signal abgibt, wenn in einer Zeile nur ein Kurvenpunkt dargestellt wird, abgenommen werden. Die Ausgangsimpulse des UND-Gliedes UG führen einzeln zur Freigabe der Darstellung von alphanumerischen Zeichen. Demgegenüber bewirkt erst der zweite Ausgangsimpuls des ODER-Gliedes OR6 innerhalb einer Zeile die Freigabe der alphanumerischen Darstellung.

0013945

## Patentansprüche

1. Aufzeichnungsgerät mit einem Aufzeichnungselement, das auf einen Aufzeichnungsstreifen in senkrecht zu dessen Vorschubrichtung verlaufenden Schreibzeilen Punkte darstellt, und mit einem Vergleicher, dem das aufzuzeichnende Signal und ein Vergleichssignal zugeführt sind und der bei Gleichheit der beiden zugeführten Signale an das Aufzeichnungselement ein Steuersignal zum Aufzeichnen eines Punktes gibt, dessen Abstand von einer Bezugslinie der Größe des aufzuzeichnenden Signals entspricht, d a d u r c h  g e k e n n - z e i c h n e t , daß zwei Vergleicher (VGL1, VGL2) vorgesehen sind, deren einen das in der einen Schreibzeile aufgezeichnete Signal und deren anderen das in der folgenden Schreibzeile aufzuzeichnende Signal und denen beiden das Vergleichssignal zugeführt ist, und daß an die Vergleicher (VGL1, VGL2) eine Verknüpfungsschaltung (EXO) angeschlossen ist, die ein Steuersignal an das Aufzeichnungselement (AFE1; AFE2) abgibt, solange das Vergleichssignal kleiner als der in der einen Schreibzeile aufgezeichnete Signalwert und größer als der in der folgenden Zeile aufzuzeichnende Signalwert ist oder solange das Vergleichssignal größer als der in der einen Schreibzeile aufgezeichnete Signalwert und kleiner als der in der folgenden Zeile aufzuzeichnende Signalwert ist.

2. Aufzeichnungsgerät nach Anspruch 1, d a d u r c h  g e k e n n z e i c h n e t , daß an einander entsprechende Vergleicherausgänge (> bzw. <), an denen bei Ungleichheit der Eingangssignale ein Ausgangssignal auftritt, die beiden Eingänge eines Exklusiv-ODER-Gliedes (EXO) angeschlossen sind, dessen Ausgangssignale als Steuersignale zum Aufzeichnen von Punkten dem Aufzeichnungselement (AFE1; AFE2) zugeführt sind.

3. Aufzeichnungsgerät nach Anspruch 1 oder 2, d a - d u r c h   g e k e n n z e i c h n e t , daß zwei Register (REG2, REG3) vorgesehen sind, in die abwechselnd die in den einzelnen Schreibzeilen aufzuzeichnenden Signale eingetragen sind, und daß an die beiden Register (REG2, REG3) jeweils ein Vergleicher (VGL1, VGL2) angeschlossen ist.

4. Aufzeichnungsgerät nach Anspruch 3, d a d u r c h   g e k e n n z e i c h n e t , daß das Aufzeichnungselement (AFE2, SK) senkrecht zur Vorschubrichtung des Aufzeichnungsstreifens hin- und herbewegt ist und daß die beiden Register (REG2, REG3) an den Umkehrpunkten des Aufzeichnungselementes abwechselnd mit dem abgetasteten aufzuzeichnenden Signal geladen sind.

5. Aufzeichnungsgerät nach einem der Ansprüche 1 bis 4, d a d u r c h   g e k e n n z e i c h n e t , daß die Ausgangssignale der Vergleicher (VGL1, VGL2), die bei Gleichheit der beiden zugeführten Signale auftreten, über ein ODER-Glied (OR1; OR6) als Steuersignale zum Aufzeichnen von Punkten dem Aufzeichnungselement (AFE1) zugeführt sind.

6. Aufzeichnungsgerät nach einem der Ansprüche 1 bis 5, d a d u r c h   g e k e n n z e i c h n e t , daß aus den Ausgangssignalen der Vergleicher (VGL1, VGL2) ein Freigabesignal für eine alphanumerische Schreibeinrichtung (ANS) gebildet wird, derart, daß alphanumerische Zeichen an anderen Stellen innerhalb der überstreichenden Schreibzeilen dargestellt werden als die aufgezeichneten Signale.

0013945

1/2

FIG 1

FIG 3

FIG 2

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | DE - A - 2 335 340 (FURUNO ELECTRIC CO.) <br><br> ✱ Seite 13, Anspruch 1 ✱ <br><br> & US - A - 3 806 948 <br><br> -- | 1 |
| A | DE - B - 2 346 010 (THE MARCONI CO.LTD.) <br><br> ✱ Spalte 1, Zeilen 1-24; Anspruch 1; Figur ✱ <br><br> -- | 1 |
| A | US - A - 4 014 011 (P.B. ASHKIN) <br><br> ✱ Spalte 1, Zeilen 52-68; Spalte 2; Spalte 3, Zeilen 1-15; Figuren 1-3b ✱ <br><br> -- | 1 |
| P | GB - A - 2 008 909 (M. MUVEK) <br><br> ✱ Seite 2, Zeilen 13-89; Figuren 1,2,4 ✱ <br><br> & FR - A - 2 423 011 <br><br> ---- | 1 |

**KLASSIFIKATION DER ANMELDUNG (Int.Cl. 3)**

G 01 R 13/00
17/04
13/40

**RECHERCHIERTE SACHGEBIETE (Int. Cl. 3)**

G 01 R 13/00
13/40
17/04
G 01 D 9/16
15/06
15/08
15/10
15/14

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 25-04-1980 | KUSCHBERT |

EPA form 1503.1  06.78